# EUROPEAN PATENT SPECIFICATION

(11) **EP 0 435 472 B1**
(45) Date of publication and mention of the grant of the patent: **04.10.1995**
(21) Application number: 90313046.6
(22) Date of filing: 30.11.1990
(51) Int. Cl.: H03H 11/04

(54) **Active filter**
Aktives Filter
Filtre actif

(30) Priority: 30.11.1989 JP 312617/89
(43) Date of publication of application: 03.07.1991
(73) Proprietor: KABUSHIKI KAISHA TOSHIBA, Kawasaki-shi, Kanagawa-ken 210 (JP)
(72) Inventor: Kusano, Takahiro, c/o Intellectual Property Div., Minato-ku, Tokyo (JP)
(74) Representative: Muir, Ian R.

(56) References cited:
- ELEKTOR, vol. 8, no. 4, April 1982, pages 4-50 - 4-51, Canterbury, Kent, GB; "The 13600, a new OTA"
- PROCEEDINGS OF THE 1987 BIPOLAR CIRCUITS AND TECHNOLOGY MEETING, Minneapolis, Minnesota, 21st - 22nd September 1987, pages 139-141, IEEE, New York, US; F. YAMAGUCHI et al.: "Single-chip Y/C signal-processing LSI for 8 mm VCR system"
- P. HOROWITZ et al.: "The art of electronics", 1980, page 7, Cambridge University Press
- Schaltbeispiele, [SIEMENS] MUNICH, DE, 1982-'83, PAGE 22, FIG. 1.5.4.

## Description

This invention relates to an active filter, and more particularly to an active filter formed in an integrated circuit.

When forming filters in an integrated circuit, active filters using a feedback technique are often formed because of difficulty in forming an inductance in the integrated circuit. A basic block of an active filter has a gain block (hereinafter called a voltage-controlled current source) which amplifies according to an incremental transfer conductance, an integrating capacitor which decides a coefficient of the filter, and an impedance transfer circuit (buffer), formed of resistors for example.

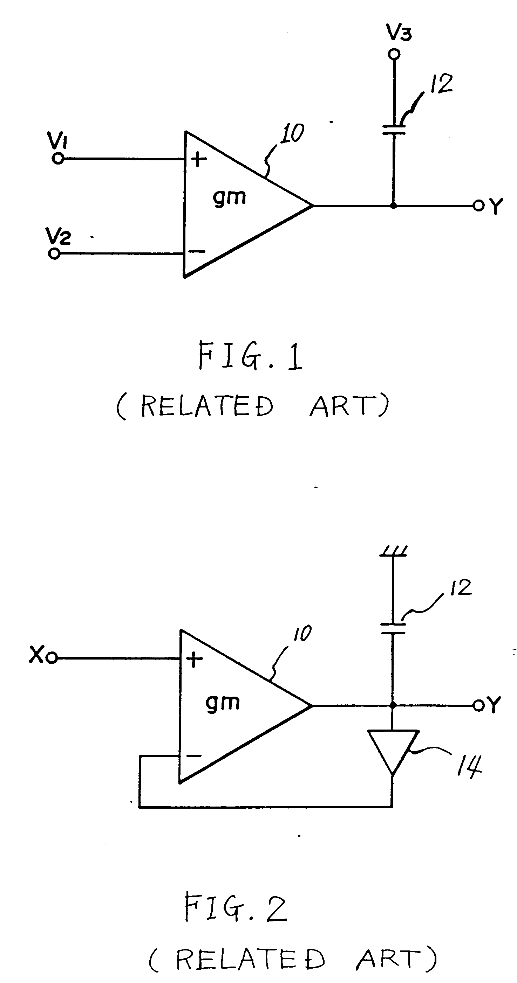

Figs. 1 and 2 show basic blocks of filters formed in integrated circuits known to the applicant. Fig. 1 shows a circuit including a differential circuit type of voltage-controlled current source 10 and an integrating capacitor 12. Fig. 2 shows a circuit including a feedback loop formed by a buffer amplifier 14 added to the circuit shown in Fig. 1. In Fig. 1, if the voltages at the non-inverting input and the inverting input of the voltage-controlled current source 10 are V₁ and V₂, respectively, and the voltage at the capacitor 12 is V₃, the output voltage Y of the circuit in Fig. 1 is as follows.$\text{Y = V₃ +} \frac{\text{gm}}{\text{SC}} \text{× (V₁ -V₂)}$
wherein gm denotes the incremental transfer conductance of the voltage-controlled current source 10, C denotes the capacitance of the capacitor 12 and S is an angular frequency.

In the equation (1), gm/C decides the coefficient of the filter. If a desired coefficient of the filter is A (a constant value), the capacitance C needed in the integrated circuit is as follows.$\text{C =} \frac{\text{gm}}{\text{A}}$
It is understood that filters with many kinds of characteristic in the integrated circuit may be formed if the capacitance C is adequately changed.

Meanwhile, capacitance C is controlled by the area used in forming the capacitor in the integrated circuit. In general, the capacitor occupies a larger area than other devices. The value of the capacitance realized in the integrated circuit has an upper limit because the area occupied by the capacitor becomes large as the capacitance increases. Thus, the filter characteristic realized in the integrated circuit has a limit, too.

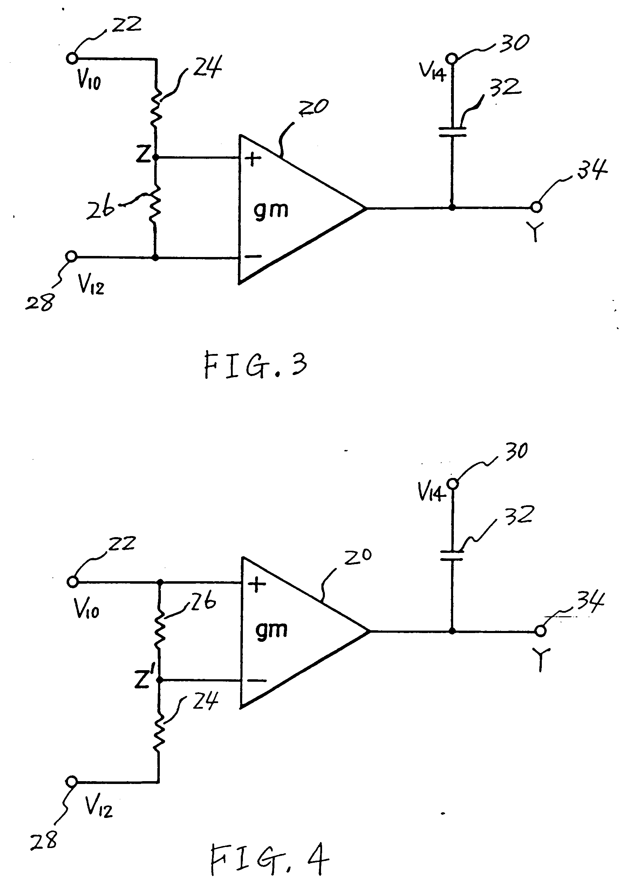

An integrated circuit active filter is shown in Elector, Vol. 8, No. 4, April ′82, GB, pages 450-451. Figure 3 shows a low pass filter formed from a voltage controlled current source (A) and a feedback resistor network (R and R_{A}). The output of the amplifier is connected to ground by a capacitor C, and the input signal is applied to the low pass filter by means of a voltage divider network.

IEEE BCTM Sept ′87 pages 139-141 (Yamaguchi et al) discloses a filter formed from two cascaded filters and an output buffer circuit. A capacitor is connected between the output of each of the filters and ground, respectively. A third capacitor is connected between the output of the buffer circuit and the output of the first filter, which capacitor enables a high Q-factor to be achieved by the circuit without the need for a high ratio between the second and first capacitors.

Accordingly, the present invention seeks to provide an improved active filter which permits a widening of the degree of freedom in design of filter characteristics realized in an integrated circuit with no increase of area of a capacitor.

In accordance with the present invention, there is provided an active filter, comprising:
a differential circuit voltage-controlled current source including a first and a second input terminal and an output terminal which is connected indirectly with the output terminal of the active filter,
a first signal source connected to the first input terminal of the voltage-controlled current source,
a second signal source, and
a capacitor connected between the second signal source and the output terminal of the voltage-controlled current source,
characterized in that the active filter further comprises
a first resistor connected between the output terminal of the active filter and the second input terminal of the voltage-controlled current source,
a second resistor connected between the first and second input terminals of the voltage-controlled current source,
a second differential circuit voltage-controlled current source including a first and second input terminal connected to the output terminal of the first voltage-controlled current source and the end of the first resistor connected to the output of the active filter, respectively, and an output terminal connected to the output terminal of the active filter, and
a capacitor connected between the output terminal of the second voltage-controlled current source and the first input terminal of the first voltage-controlled current source.

Other features, and advantages of the present invention will become apparent from the following detailed description. It should be understood, however, that the detailed description and specific examples, while indicating preferred embodiments of the invention, are given by way of illustration only, since various changes and modifications within the scope of the appended claims will become apparent to those skilled in the art from this detailed description.

A more complete appreciation of the present invention and many of its attendant advantages will be readily obtained by reference to the following detailed description considered in connection with the accompanying drawings, in which:

Figures 1 to 5 each show a circuit diagram of an active filter known to the applicant.

Figure 6 shows a circuit diagram of an active filter according to the present invention.

Figure 7 shows a circuit diagram of one example of the voltage-controlled current sources shown in Figures 3 to 6.

Where, in the drawings, the same numerals are applied to similar elements, the detailed descriptions thereof are not repeated.

Fig. 3 is a circuit diagram of an active filter known to the applicant.

A voltage-controlled current source 20 is of differential circuit type. The non-inverting input of the voltage-controlled current source 20 is connected to a first signal source 22 through a resistor 24. A resistor 26 is connected between the non-inverting input and the inverting input of the voltage-controlled current source 20. The inverting input of the voltage-controlled current source 20 is connected to a second signal source 28. The output terminal of the voltage-controlled current source 20 is connected to a third signal source 30 through an integrating capacitor 32. An output terminal 34 is connected to the output terminal of the voltage-controlled current source 20.

The voltage at the non-inverting input of the voltage-controlled current source 20 is as follows.$\text{Z =} \frac{\text{R₂ · V₁₀ + R₁ · V₁₂}}{\text{R₁ + R₂}}$
wherein R₁ and R₂ are the resistance value of the resistors 24 and 26, respectively. V₁₀ and V₁₂ mean the voltages of the first and the second signal source 22, 28, respectively.

The voltage at the output terminal 34 is as follows.$\text{Y = V₁₄ +} \frac{\text{1}}{\text{SC}} \text{× gm × (Z - V₁₂)} \text{= V₁₄ +} \frac{\text{gm}}{\text{SC}} \text{× (} \frac{\text{R₂ · V₁₀ + R₁ · V₁₂}}{\text{R₁ + R₂}} \text{- V₁₂)} \text{= V₁₄ +} \frac{\text{gm}}{\text{SC}} \text{× (V₁₀ - V₁₂) ×} \frac{\text{R₂}}{\text{R₁ + R₂}}$

As compared with the equation (1), the equation (4) shows that the incremental transfer conductance gm of the filter in Fig. 3 is reduced to R₂/(R₁ + R₂) (< 1) times that of the filter shown in Fig. 1. That is, the same filter characteristic as that of the related art is realized with area multiplied R₂/(R₁ + R₂).

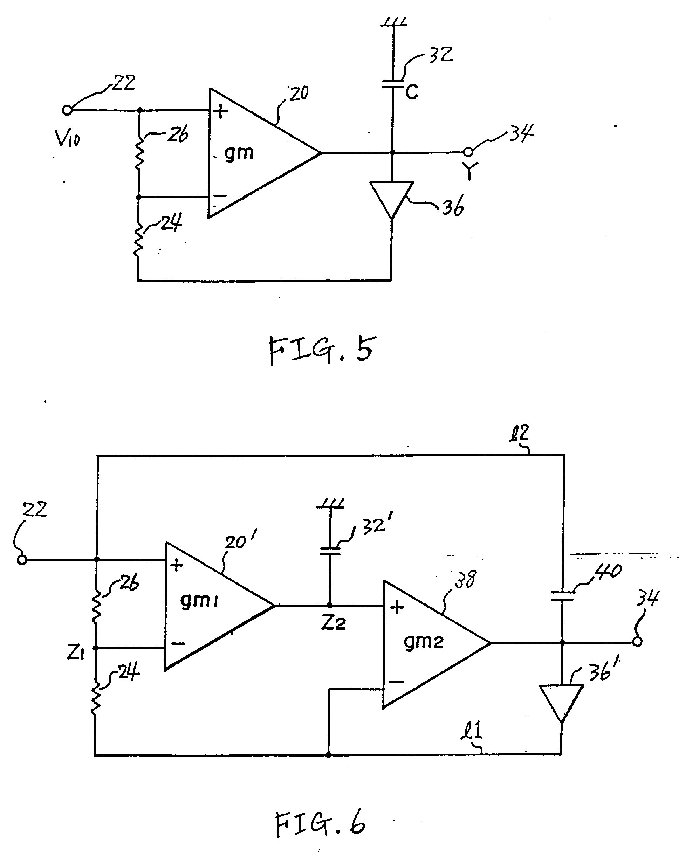

Fig. 4 is a circuit diagram of another active filter known to the applicant.

In this arrangement, the first signal source 22 is connected directly to the non-inverting input of the voltage-controlled current source 20. The second signal source 28 is connected to the inverting input of the voltage-controlled current source 20 through the resistor 24.

The voltage at the inverting input of the voltage-controlled current source 20 is as follows.$\text{Z′ =} \frac{\text{R₁ · V₁₀ + R₂ · V₁₂}}{\text{R₁ + R₂}}$
The voltage at the output terminal 34 is as follows.$\text{Y = V₁₄ +} \frac{\text{1}}{\text{SC}} \text{× gm × (V₁₀ - Z′)} \text{= V₁₄ +} \frac{\text{gm}}{\text{SC}} \text{× (V₁₀ -} \frac{\text{R₁ · V₁₀ + R₂ · V₁₂}}{\text{R₁ + R₂}} \text{)} \text{= V₁₄ +} \frac{\text{gm}}{\text{SC}} \text{× (V₁₀ - V₁₂) ×} \frac{\text{R₂}}{\text{R₁ + R₂}}$
The equation (6) is the same as the equation (4), and thus the same advantages are realised with this enbodiment.

Fig. 5 is a circuit diagram of a further active filter known to the applicants.

In this embodiment, a feedback loop is added to the circuit shown in Fig. 4. That is, the inverting input of the voltage-controlled current source 20 has a feedback signal as an input signal in place of the signal from the second signal source 28. A buffer amplifier 36 is connected to the output terminal 34. The output terminal of the amplifier 36 is connected to the inverting input of the voltage-controlled current source 20 through the resistor 24. A reference third signal source is supplied to the integrating capacitor 32.

In this arrangement, the incremental transfer conductance of the voltage-controlled current source 20 is also smaller than that of the filter shown in Fig. 1. The area of the capacitor is reduced. In this case, if V₁₂ and V₁₄ equal Y and zero, respectively for example, in the equation (6), the following equation is obtained:$\text{Y =} \frac{\text{gm}}{\text{SC}} \text{× (V₁₀ - Y) × α}$$\text{α =} \frac{\text{R₂}}{\text{R₁ + R₂}} \text{< 1}$

From the equation (7), the transfer function of the circuit shown in Fig. 5 is as follows.$\frac{\text{Y}}{\text{V₁₀}} \text{=} \frac{\text{α} \frac{\text{gm}}{\text{C}}}{\text{S + α} \frac{\text{gm}}{\text{C}}}$
The above equation has a characteristic of a primary low-pass filter.

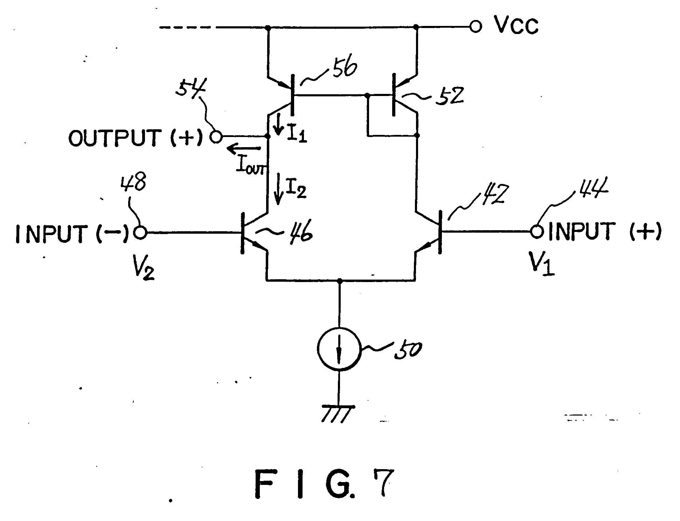

Fig. 6 is a circuit diagram of an active filter of the invention. This circuit forms a secondary low-pass filter including two differential circuit type voltage-controlled current sources. An output terminal of a first differential circuit type of voltage-controlled current source 20′ is connected to a capacitor 32′, and a non-inverting input of a second differential circuit type of voltage-controlled current source 38. The inverting input of this voltage-controlled current source 38 is connected to the resistor 24. The output terminal of the voltage-controlled current source 38 is connected to the output terminal 34, an integrating capacitor 40 and a buffer amplifier 36′. The output terminal of this amplifier 36′ is connected to the resistor 24. The output of the amplifier 36′ is supplied to the inverting inputs of the voltage-controlled current sources 20′ and 38 through the resistor 24 or directly as a feedback input through a feedback route ℓ₁. The output terminal 34 and the input terminal 22 are connected through a feedback route ℓ₂ including the capacitor 40.

In this embodiment, the value of the incremental transfer conductance of the first voltage-controlled current source 20′ becomes small according to the value of the resistors 24 and 26. The capacitance of the capacitor 32′ may be made small enough to realize the same filter characteristic as that of prior secondary low-pass filters using two voltage-controlled current sources.

The invention may be adapted to high order filters as well as primary filters as mentioned above. Additionally, high order filters under the invention are, for example, realized by connecting the circuits shown in Figs. 5 and 6 serially.

The voltage-controlled current sources in Figs. 3 to 6 are realized by a circuit such as shown in Fig. 7. That is, the base of a transistor 42 is connected to an input terminal (a non-inverting input) 44. The base of a transistor 46 is connected to an input terminal (an inverting input) 48. The emitters of the transistors 42, 46 are connected to a constant current source 50. The transistors 42 and 46 form a differential circuit. The collector of the transistor 42 is connected to a transistor 52 which operates as a diode. The collector of the transistor 46 is connected to an output terminal 54 and the collector of a transistor 56. The base of the transistor 56 is connected to the base of the transistor 52. The transistors 52 and 56 form a current mirror circuit.

The operation of the circuit shown in Fig. 7 is described below.

For example, when the voltage at the base of the transistor 42 increases, the collector currents of the transistors 42 and 46 increases and decreases, respectively. The collector current of the trasistor 52 equals the collector current of the transistor 56. Thus, when the voltage V₁ at the input terminal 44 increases (the voltage V₂ at the input terminal 48 is supposed to be constant or decrease), the collector currents I₁ and I₂ of the transistors 56 and 46 increase and decrease , respectively. The difference between the values of the collector currents of the transistors 56 and 46 equals the value of the current from the output terminal 54. The output current I_{OUT} from the output terminal 54 is as follows.${\text{I}}_{\text{OUT}} \text{= I₁ - I₂ = gm × (V₁ - V₂)}$

That is, the output current I_{OUT} of the circuit shown in Fig. 7 is controlled by the input voltages V₁ and V₂.

## Claims

1. An active filter, comprising:
a differential circuit voltage-controlled current source (20) including a first and a second input terminal and an output terminal which is connected indirectly with the output terminal of the active filter,
a first signal source (22) connected to the first input terminal of the voltage-controlled current source (20),
a second signal source, and
a capacitor (32) connected between the second signal source and the output terminal of the voltage-controlled current source (20),
characterized in that the active filter further comprises
a first resistor (24) connected between the output terminal of the active filter and the second input terminal of the voltage-controlled current source (20),
a second resistor (26) connected between the first and second input terminals of the voltage-controlled current source (20),
a second differential circuit voltage-controlled current source (38) including a first and second input terminal connected to the output terminal of the first voltage-controlled current source (20′) and the end of the first resistor (24) connected to the output of the active filter, respectively, and an output terminal connected to the output terminal of the active filter, and
a capacitor (40) connected between the output terminal of the second voltage-controlled current source (38) and the first input terminal of the first voltage-controlled current source (20′).

2. An active filter as claimed in claim 1, further comprising a buffer amplifier (36′) connected between the output terminal of the active filter and the first resistor (24).

3. An active filter as claimed in claim 1, wherein the second signal source has a voltage of ground.

4. An active filter as claimed in claim 1, wherein the first and the second input terminal of the voltage-controlled current source (20) are a non-inverting input and an inverting input, respectively.

## Patentansprüche

1. Aktiver Filter, der aufweist:
eine spannungsgesteuerte Differenzschaltungs-Stromquelle (20), die einen ersten Eingangsanschluß und einen zweiten Eingangsanschluß und einen Ausgangsanschluß enthalt, der indirekt mit dem Ausgangsanschluß des aktiven Filters verbunden ist,
eine erste Signalquelle (22), die mit dem ersten Eingangsanschluß der spannungsgesteuerten Stromquelle (20) verbunden ist,
eine zweite Signalquelle, und
einen Kondensator (32), der zwischen der zweiten Signalquelle und dem Ausgangsanschluß der spannungsgesteuerten Stromquelle (20) verbunden ist,
dadurch gekennzeichnet, daß der aktive Filter weiterhin aufweist
einen ersten Widerstand (24), der zwischen dem Ausgangsanschluß des aktiven Filters und dem zweiten Eingangsanschluß der spannungsgesteuerten Stromquelle (20) verbunden ist,
einen zweiten Widerstand (26), der zwischem dem ersten Eingangsanschluß und dem zweiten Eingangsanschluß und der spannungsgesteuerten Stromquelle (20) verbunden ist,
eine zweite spannungsgesteuerte Differenzschaltungs-Stromquelle (38), die einen ersten Eingangsanschluß und einen zweiten Eingangsanschluß, die mit dem Ausgangsanschluß der ersten spannungsgesteuerten Stromquelle (20′) bzw. mit dem Ende des ersten Widerstands (24) verbunden sind, der mit dem Ausgang des aktiven Filters verbunden ist, und einen Ausgangsanschluß enthalt, der mit dem Ausgangsanschluß des aktiven Filters verbunden ist, und
einen Kondensator (40), der zwischen dem Ausgangsanschluß der zweiten spannungsgesteuerten Stromquelle (38) und dem ersten Eingangsanschluß der ersten spannungsgesteuerten Stromquelle (20′) verbunden ist.

2. Aktiver Filter, wie in Anspruch 1 beansprucht, der weiterhin einen Pufferverstarker (36′) aufweist, der zwischen dem Ausgangsanschluß des aktiven Filters und dem ersten Widerstand (24) verbunden ist.

3. Aktiver Filter, wie in Anspruch 1 beansprucht, worin die zweite Signalquelle eine Masse-Spannung hat.

4. Aktiver Filter, wie in Anspruch 1 beansprucht, worin der erste Eingangsanschluß und der zweite Eingangsanschluß der spannungsgesteuerten Stromquelle (20) ein nichtinvertierender Eingang bzw. ein invertierender Eingang sind.

## Revendications

1. Un filtre actif comprenant :
une source de courant à tension commandée (20) de circuit différentiel comprenant une première et une seconde borne d'entrée, et une borne de sortie qui est connectée indirectement à la borne de sortie du filtre actif,
une première source de signaux (22) connectée à la première borne d'entrée de la source de courant à tension commandée (20),
une seconde source de signaux, et
un condensateur (32) connecté entre la seconde source de signaux et la borne de sortie de la source de courant à tension commandée (20),
caractérisé en ce que le filtre actif comprend en outre une première résistance (24) connectée entre la borne de sortie du filtre actif et la seconde borne d'entrée de la source de courant à tension commandée (20),
une seconde résistance (26) connectée entre les première et seconde bornes d'entrée de la source de courant à tension commandée (20),
une seconde source de courant à tension commandée (38) de circuit différentiel présentant une première et une seconde borne d'entrée connectée à la borne de sortie de la première source de courant à tension commandée (20′) et l'extrémité de la première résistance (24) connectée à la sortie du filtre actif, respectivement, et une borne de sortie connectée à la borne de sortie du filtre actif, et
un condensateur (40) connecté entre la borne de sortie de la seconde source de courant à tension commandée (38) et la première borne d'entrée de la première source de courant à tension commandée (20′).

2. Un filtre actif comme revendiqué à la revendication 1, comprenant en outre un amplificateur séparateur (36′) connecté entre la borne de sortie du filtre actif et la première résistance (54).

3. Un filtre actif comme revendiqué à la revendication 1, dans lequel la seconde source de signaux à une tension de terre.

4. Un filtre actif comme revendiqué à la revendication 1, dans lequel la première et la seconde borne d'entrée de la source de courant à tension commandée (20) sont une entrée non inverseuse et une entrée inverseuse, respectivement.
